**Europäisches Patentamt**

**European Patent Office**

**Office européen des brevets**

(11) Publication number: **0 061 938**
**B1**

(12) **EUROPEAN PATENT SPECIFICATION**

(45) Date of publication of patent specification: **08.06.88**

(51) Int. Cl.⁴: **H 01 L 33/00**

(21) Application number: **82301710.8**

(22) Date of filing: **31.03.82**

(54) **Light emitting semiconductor device.**

(30) Priority: **31.03.81 JP 47982/81**

(43) Date of publication of application:
**06.10.82 Bulletin 82/40**

(45) Publication of the grant of the patent:
**08.06.88 Bulletin 88/23**

(84) Designated Contracting States:
**DE FR GB**

(56) References cited:
**ELECTRONICS LETTERS, vol. 17, no. 6, 19th March 1981, pages 226-227, London, GB; Y. NODA et al.: "High temperature CW operation of 1.5 mum InGaAsP/InP buffer-layer loaded planoconvex waveguide lasers"**

**RCA REVIEW, vol. 39, no. 2, June 1978, pages 278-308, Princeton, USA; W. KERN: "Chemical etching of silicon, germanium, gallium arsenide, and gallium phosphide"**

**ELECTRONICS LETTERS, vol. 17, no. 18, 3rd September 1981, pages 651-653, London, GB; W.J. DEVLIN et al.: "Low threshold channelled-substrate buried crescent InGaAsP lasers emitting at 1.54 mum"**

(73) Proprietor: **FUJITSU LIMITED**
**1015, Kamikodanaka Nakahara-ku Kawasaki-shi Kanagawa 211 (JP)**

(72) Inventor: **Ishikawa, Hiroshi**
**Kopo-K 101 3-10-18, Todoroki Setagaya-ku Tokyo 158 (JP)**
Inventor: **Takagi, Nobuyuki**
**1-3-908, Wakabadai Asahi-ku Yokohama-shi Kanagawa 241 (JP)**
Inventor: **Imai, Hajime**
**803, 1-7-23, Kinuta Setagaya-ku Tokyo 157 (JP)**

(74) Representative: **Fane, Christopher Robin King et al**
**HASELTINE LAKE & CO. Hazlitt House 28 Southampton Buildings Chancery Lane London, WC2A 1AT (GB)**

(56) References cited:
**ELECTRONICS LETTERS, vol. 17, no. 13, 25th June 1981, pages 465-467; H. ISHIKAWA et al.: "V-grooved substrate buried heterostructure InGaAsP/InP laser"**

EP 0 061 938 B1

# 0 061 938

**Description**

The present invention relates to a light emitting semiconductor device, such as a semiconductor laser having light wave guide built therein.

Recently, semiconductor devices have been developed which comprise a light wave guide formed by burying an active layer in a groove in a semiconductor substrate and enclosing the active layer within low-refractive indexed semiconductor materials, e.g., of an InP or an AlGaAs system.

These semiconductor systems exhibit a zinc blend type crystal structure and expose conventionally a (111)A facet by etching a (100) plane of the crystal.

Zh. L. Alferov, et al., "AlGaAs Heterostructure with Confined Current Flow" in Sov. Phys. Tech. Phys. 22 (8) *1977*, 1032~1036 (August, 1977) recite that (111)A facets are exposed by etching the crystal with various etchants. However, Alferov, et al. do not teach to expose a (111)B facet.

JP—A—56158496 by W. Suzuki, et al. (Mitsubishi Denki K. K. Mitsubishi Electric Corporation), discloses that an InGaAsP/InP laser is produced by burying an InGaAsP active layer in InP by a two-step liquid phase epitaxial technique and that a dovetail-shaped groove is etched along the <011> direction and a V-shaped groove is etched orthogonal to the dovetail groove, i.e., parallel to the <01$\bar{1}$> direction.

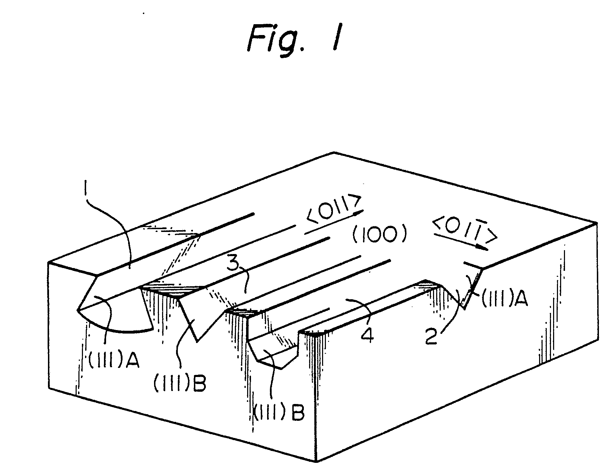

These grooves, either dovetail-shaped or V-shaped, have inclined side planes of a (111)A facet. The shapes and directions of these grooves are shown at 1 and 2 in Fig. 1. However, these grooves 1 and 2 having a (111)A facet have the following disadvantages. A dovetail-shaped groove 1 has a curved active layer grown expitaxially along the curvature of the bottom of the groove, which leads to unstable transverse mode oscillation. In addition, the side edges of the groove 1 tend to be etched off by melting. A V-shaped groove 2 often suffers from poor eptaxial growth, because it is not always filled up by the grown layers.

The present inventors conducted experiments to determine the percentage of successfully grown InGaAsP active layers in the transverse section of InP V-shaped grooves having (111)A facets. The results are shown in Table 1, which shows the relationship between the percentage of successfully grown active layers, the cooling rate, and supercooling. As shown in the table, the yield is generally low. In addition, further defective portions remained in the longitudinal direction of the grooves. Therefore, it is impossible to use the resultant products as lasers.

TABLE 1
Percentage of successful growth

(unit: %)

| Supercooling (°C) | Cooling rate (°C/min) | | | | |
|---|---|---|---|---|---|
| | 0.05 | 0.1 | 0.2 | 0.3 | 0.7 |
| 7 | — | 85 | 83 | 38 | 20 |
| 9 | — | 85 | — | — | — |
| 10 | 90 | 80 | 82 | 30 | — |
| 11 | 62 | 59 | 53 | — | — |
| 14 | 60 | 52 | — | 30 | 0 |

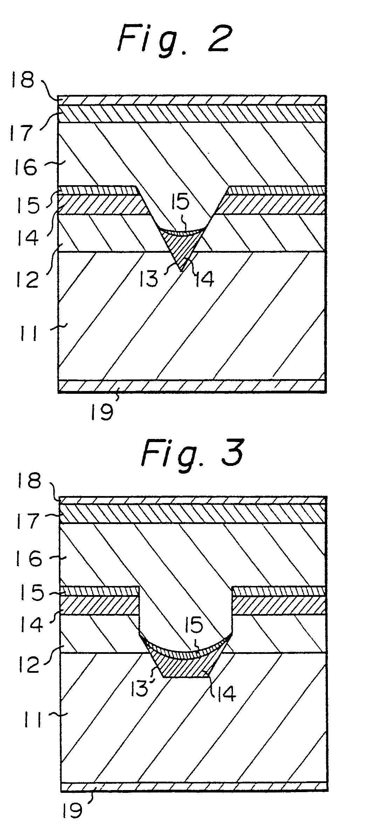

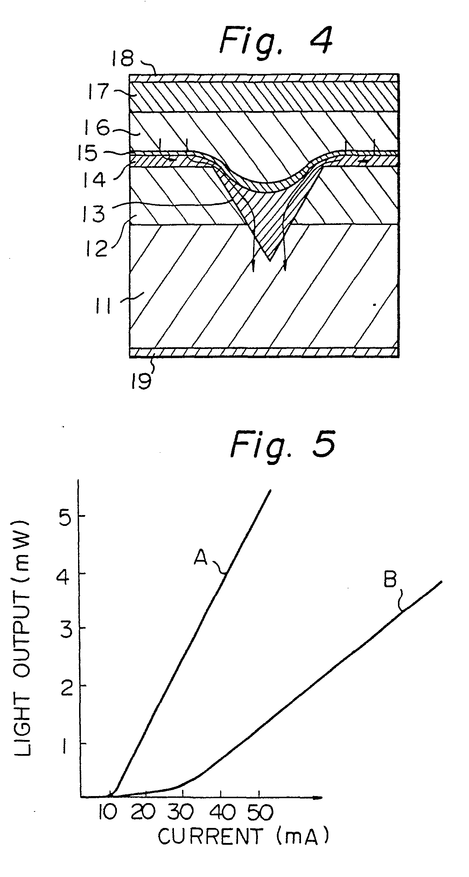

JP—A—523392 by Robert D. Burnham, et al. (Xerox Corporation) discloses an AlGaAs/GaAs light emitting semiconductor device in which the AlGaAs active layer within a groove is connected with AlGaAs layers grown outside of the groove. The current which flows through the layers outside of the groove does not pass through the active layer. Figure 5 shows the relationship between light output and current in InGaAsP/InP light emitting semiconductor devices obtained by our experiments. The upper width of the grooves was 3.6 μm and the measurement is performed at the temperature of 50°C. Curve A was obtained using a device in which the InGaAsP layer 15 in the groove 13 was separated from layers 15 outside of the groove 13, as shown in Fig. 2; curve B was obtained using a device in which the InGaAsP layer 15 continuously covers an n-InP layer 14, as shown in Fig. 4. The light output of curve B is relatively low in relation to the current. Thus, it is clear that the side edges of an active layer should not contact an InGaAsP layer outside of the groove.

According to the present invention there is provided a light emitting semiconductor device comprising an active layer buried in a groove, which groove has been formed in a body of semiconductor material at a main face of that body, characterised in that the said active layer consists of InGaAsP and the said semiconductor material is InP, and in that respective (111)B facets of an InP crystal, which facets are inclined with respect to the said main face, provide at least parts of the opposite side boundaries of the said groove.

2

An embodiment of the present invention can provide a light emitting semiconductor device having a relatively stable transverse mode oscillation, with a smooth near field pattern.

Such a device can be made so as to provide a light output which is high relative to current.

An embodiment of the present invention can provide a light output which increases in linear proportion with the increase of current.

A light emitting semiconductor device embodying the present invention can be produced with a high yield.

In one preferred embodiment the transverse section of said groove has a V-shape.

In another preferred embodiment the transverse section of said groove has a five-sided U-shape.

It can be advantageous if the upper width of said groove is less than 4 µm.

In a preferred embodiment said InP crystal which has inclined side planes of (111)B facet, is a p-InP layer grown on an n-InP substrate or a p-InP layer made by diffusion process on an n-InP substrate.

A light emitting semiconductor device embodying the present invention is produced by etching a (100) plane of an InP crystal having a zinc blend type structure, so as to form a groove in the <011> direction, an inclined side boundary of which groove is a (111)B facet of the InP crystal. The edges of the InGaAsP active layer can smoothly grow on the n-InP clad layer along the groove, so as to make a smooth near field pattern. In addition, the edges of the active layer do not contact the InGaAsP layer outside of the groove, so that the current passes entirely through the active layer and so that the emitting eficiency and linearity of light output to current are improved.

The groove may be either V-shaped or five-sided U-shaped. The etchant may be an $HCl-H_3PO_4$ solution or an $HCl-HNO_3$ solution. The groove only has a five-sided U-shape with a ratio of $HCl/HNO_3$ less than 1:1. When the upper width of the groove is less than 4.0 µm, the active layer can grow in contact with the inclined side plane of the groove so as to improve the emitting efficiency and linearity of light output to current. After the active layer grows on the n-InP clad layer in the groove, a p-InP clad layer and a p-InGaAsP cap layer are epitaxially grown sequentially. Thus, the light emitting device is produced by a two-step liquid phase epitaxial technique. Fabrication by a one-step liquid phase epitaxial technique can also be successfully performed by employing a diffusion process for the formation of the P-InP layer. Fabrication by a one-step liquid phase epitaxial technique without a diffusion process is also possible, as follows: A groove is formed in an n-InP semiconductor substrate. Then; an n-InP clad layer, an InGaAsP active layer, a p-type clad layer, and an InGaAsP cap layer are sequentially grown by a one-step liquid phase epitaxial technique. The restriction of current is effected by providing either an insulation layer, e.g., of silicon dioxide, having a stripe-shaped opening or a stripe-shaped p-type impurity diffusion region opened in the n-type cap layer. However, such a light emitting device is rather disadvantageous, i.e., some of the current passes out of the groove, which leads to a lower intensity of the laser beam.

Brief description of the drawings

Figure 1 is a perspective view of a substrate having grooves 3 and 4 according to the present invention and grooves 1 and 2 of the prior art;

Figure 2 is a transverse section of an embodiment of a light emitting semiconductor device embodying the present invention;

Figure 3 is a transverse section of another embodiment of a light emitting semiconductor device embodying the present invention;

Figure 4 is a transverse section of a light emitting semiconductor device, in which an active layer covers continuously an n-InP layer;

Figure 5 is a graph showing the relationship between light output and current at the temperature of 50°C obtained from a light emitting device embodying the present invention (A) and a prior device (B);

Figure 6 shows an enlarged transverse section of an active layer in a semiconductor device;

Figure 7 is a graph showing the relationship between light output and current obtained from a light emitting semiconductor device; an angle θ is also shown;

Figure 8 is a graph showing the relationship between tangent θ and the total length of an uncovered portion of a clad guide layer in the groove;

Figure 9 is a graph showing the relationship between the total length of the uncovered portion of the clad guide layer in the groove and the upper width L of the groove;

Figure 10A is a graph showing the relationship between light output and current obtained from a light emitting semiconductor device having an upper width L less than 4.0 µm;

Figure 10B is a graph similar to Fig. 10A obtained from a light emitting device having an upper width L of more than 4.0 µm.

An InGaAsP/InP double hetero junction laser, which has a strip-shaped groove 3 or 4 along the <011> direction of an n-InP substrate as shown in Fig. 1, was produced as an embodiment of the present invention.

Referring to Figs. 2 and 3, a p-InP current restriction layer 12 with a thickness of ca. 1.5 µm was formed on a (100) plane of an n-InP substrate 11 by liquid phase epitaxial growth or impurity diffusion. An elongate groove 13 was formed along the <011> direction of the n-InP substrate 11 by means of photolithography and chemical etching through the p-InP current restriction layer 12 down into the n-InP substrate 11. The etching was carried out using an $HCl-H_3PO_4$ solution or an $HCl-HNO_3$ solution as the etchant. These etchants exposed a mirror surface (111) B facet of the p-InP current restriction layer 12 as an inclined plane boundary portion at each side of each groove. Both etchants could form V-shaped groove indicated as 3 in Fig. 1 or 13 in Fig. 2. When the ratio of HCl to $HNO_3$ was less than 1:1, a five-sided U-shaped groove was formed, indicated as 4 in Fig. 1 or 13' in Fig. 3.

Then, an n-InP clad layer 14, a non-doped InGaAsP active layer 15, a p-InP clad layer 16, and a p-InGaAsP cap layer 17 were sequentially grown by liquid phase epitaxial growth. The thickness of these layers 14, 15, 16 and 17 were, for example 0.3 to 0.8, ca. 0.2, ca. 1.5, and ca. 0.5 μm, respectively. Thereafter, a p-side electrode 18 and an n-side electrode 19 were produced as usual.

Table 2 shows the percentage of active layers 15 successfully grown at various cooling rates and various supercoolings on a V-shaped groove 13, the inclined side plane of which was the (111) B facet of the p-InP current restriction layer 12. The yield was 100%. In addition, as the active layers 15 began to grow from the narrow bottom of the n-InP clad layer 14, the curvature of the transverse section of the active layers 15 was relatively small. The active layer 15 grown in the five-sided U-shaped groove 13' also exhibits acceptable performance.

TABLE 2
Percentage of successful growth

(unit: %)

| Supercooling (°C) | Cooling rate (°C/min) | | | | |
|---|---|---|---|---|---|
| | 0.05 | 0.1 | 0.2 | 0.3 | 0.7 |
| 7 | — | 100 | 100 | 100 | 100 |
| 9 | — | 100 | — | — | — |
| 10 | 100 | 100 | 100 | 100 | — |
| 11 | 100 | 100 | 100 | — | — |
| 14 | 100 | 100 | — | 100 | 100 |

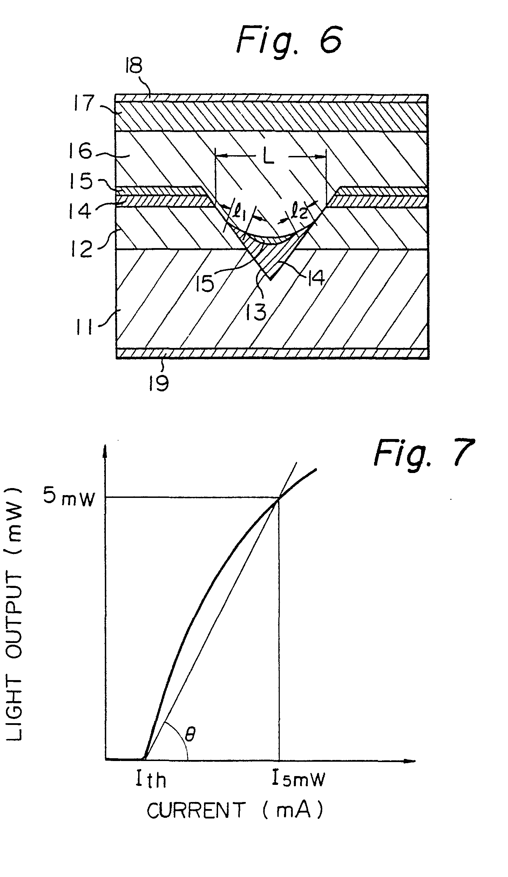

In order to obtain the optimum relationship between light output and current, following experiments were carried out. As seen from Fig. 6, $l_1$ and $l_2$ correspond to the length of transverse sections of an n-InP clad layer 14 which are not covered with the active layer 15, and L corresponding to the upper width of the groove 13.

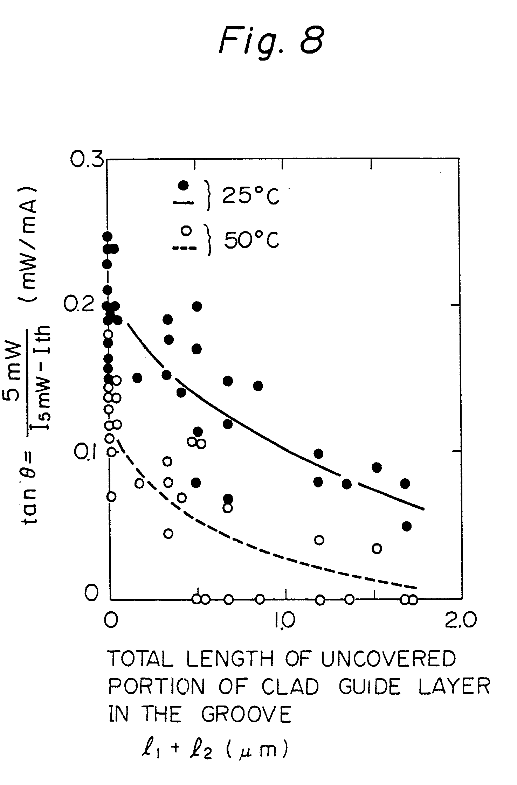

Figure 7 shows the relationship between light output and current of a light emitting semiconductor device having an InGaAsP active layer buried in the groove. As the current increases, light begins to emit at a threshold current $I_{th}$ and gradually increases. Conveniently, a point was set for light output of 5 mW, then, the relationship between 5 mW $(I_{5mW}-I_{th})^{-1}$ and the total length of $l_1$ and $l_2$ was plotted as shown in Fig. 8. The plotted dots ● and ○ were obtained at 25°C and 50°C, respectively. The solid line and the broken line were obtained referring to the dots ● and ○, respectively. The term 5 mW$(I_{5mW}-I_{th})^{-1}$ corresponds to tangent θ as shown in Fig. 7.

As seen from Fig. 8, when the total length of $l_1$ and $l_2$ is zero, i.e. the opposite edges of the active layer 15 are in contact respectively with the (111)B facets of the p-InP layer 12 bounding the groove at opposite sides thereof, tangent θ is maximum.

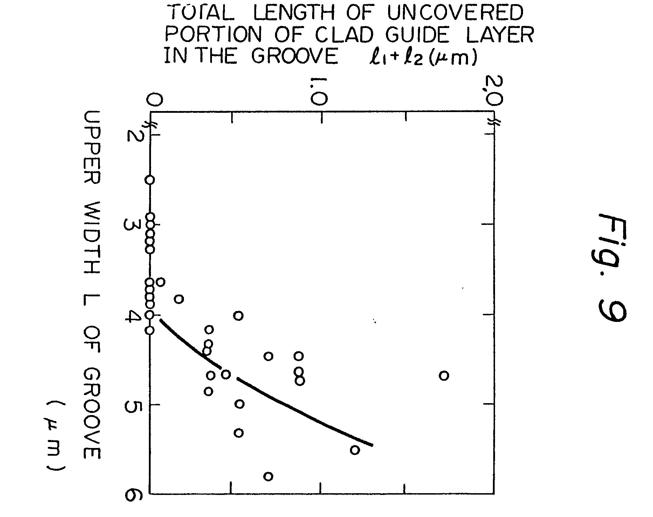

Figure 9 shows the relationship between the total length of $l_1+l_2$ and the upper width L of the groove. When the width L is less than 4 μm, the total length of $l_1+l_2$ decreases to zero. Thus the side edges of the active layer 15 cover completely the clad layer material 14 in the groove, when the upper (maximum) width L of the groove 13 is less than 4 μm. This applies also in the case of a five-sided U-shaped groove such as that shown in Figure 3, that is to say a groove which is bounded by two opposite side boundary portions, which extend vertically, a horziontal bottom boundary portion, and two inclined (111)B facet portions which join the said opposite side boundary portions respectively to opposite edges of the bottom boundary portion.

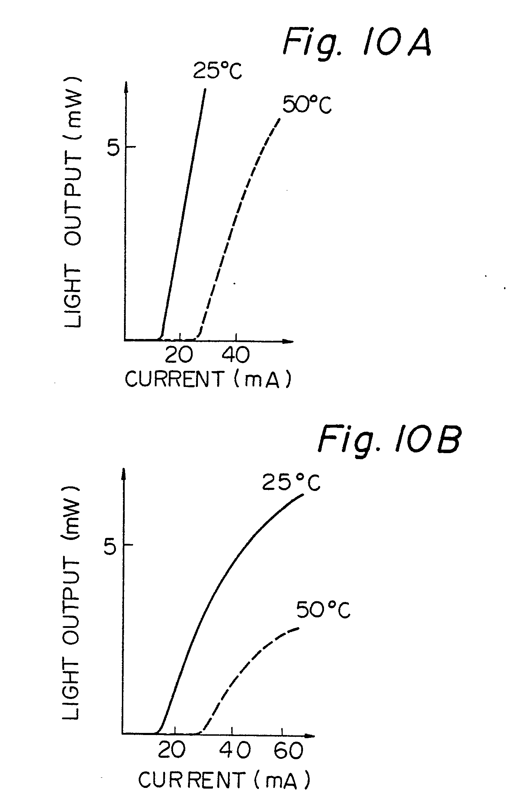

Figures 10A and 10B, similar to Fig. 7, illustrate the relationship between light output and current of a light emitting semiconductor device obtained at 25°C and 50°C. The upper width L of the grooves of the devices used in the experiments of Figs. 10A and 10B were 3.6 μm and 4.7 μm, respectively.

Figure 10A shows that light output increases in linear proportion with the increase of current in the case where the side edges of the active layer contact the (111)B facets of the current restriction layer 12. On the other hand, Fig. 10B shows that light output does not increase in linear proportion with current in the case where the side edges of the active layer 15 do not contact the (111)B facets of the p-InP current restriction layer 12, i.e., the total length of uncovered portion of the n-InP clad guide 14 is e.g. 0.6 μm.

**Claims**

1. A light emitting semiconductor device comprising an active layer (15) buried in a groove (13), which groove has been formed in a body (11, 12) of semiconductor material at a main face of that body, characterised in that the said active layer (15) consists of InGaAsP and the said semiconductor material is InP, and in that respective (111)B facets of un InP crystal, which facets are inclined with respect to the said main face, provide at least parts of the opposite side boundaries of the said groove.

2. A device as claimed in claim 1, wherein the opposite edges of the active layer are in contact respectively with the said opposite side boundaries of the groove.

3. A device as claimed in claim 1 or 2, wherein the groove is V-shaped in transverse section.

4. A device as claimed in claim 1 or 2, wherein the said groove (13) is bounded by two opposite side boundary portions, which extend from the said main face into the said body substantially perpendicularly to that main face, a bottom boundary portion extending substantially parallel to the said main face, and two inclined boundary portions which are provided respectively by the said (111)B facets and join the said opposite side boundary portions respectively to opposite edges of the said bottom boundary portion.

5. A device as claimed in claim 3 or 4, wherein the maximum width of the groove is 4 μm.

6. A device as claimed in any preceding claim, wherein the said body of semiconductor material comprises a substrate (11) of n-type InP with a layer (12) of p-type InP formed thereon, and wherein the groove (13) extends in depth through the layer of p-type InP into the said substrate.

**Patentansprüche**

1. Lichtemittierende Halbleitervorrichtung mit einer aktiven Schicht (15), die in einer Nut (13) begraben ist, welche Nut in einem Körper (11, 12) des Halbleitermaterials an einer Hauptoberfläche des Körpers gebildet ist, dadurch gekennzeichnet, daß die genannte aktive Schicht (15) aus InGaAsP und das genannte Halbleitermaterial aus InP besteht, und daß jeweilige (111)B-Kristallflächen des InP-Kristalls, welche Kristallflächen bezüglich der genannten Hauptoberfläche geneigt sind, wenigstens Teile der gegenüberliegenden Grenzabschnitte der genannten Nut bilden.

2. Vorrichtung nach Anspruch 1, bei der gegenüberliegenden Ränder der aktiven Schicht jeweils mit den genannten seitlichen Grenzabschnitten der gegenüberliegenden Seiten der Nut in Kontakt sind.

3. Vorrichtung nach Anspruch 1 oder 2, bei der die Nut im Querschnitt V-förmig ist.

4. Vorrichtung nach Anspruch 1 oder 2, bei der die genannte Nut (13) durch zwei gegenüberliegende seitliche Grenzabschnitte, welche sich von der genannten Hauptoberfläche im wesentlichen senkrecht zu der genannten Hauptoberfläche in den genannten Körper erstrecken, einen Bodengrenzabschnitt, der sich im wesentlichen parallel zu der genannten Hauptoberfläche erstreckt, und zwei geneigte Grenzabschnitte, die durch entsprechende (111)B-Kristallflächen gebildet sind und die jeweils die genannten gegenüberliegenden seitliche Grenzabschnitte mit gegenüberliegenden Rändern des genannten Bodengrenzabschnittes verbinden, begrenzt ist.

5. Vorrichtung nach Anspruch 3 oder 4, bei der die maximale Breite der Nut 4 μm ist.

6. Vorrichtung nach einem der vorhergehenden Ansprüche, bei der der genannte Körper aus Halbleitermaterial ein Substrat (11) aus n-Typ-InP ist, mit einer darauf geformten Schicht (12) aus p-Typ-InP, und bei der die Nut (13) sich in der Tiefe durch die Schicht aus p-Typ-InP in das genannte Substrat erstreckt.

**Revendications**

1. Composant semi-conducteur électroluminescent comportant une couche active (15) encastrée dans une rainure (13), cette rainure ayant été formée dans un corps (11, 12) de matière semi-conductrice à une face principale de ce corps, caractérisé en ce que ladite couche active (15) consiste en InGaAsP alors que ladite matière semi-conductrice est InP et en ce que les facettes respectives (111)B d'un cristal InP, ces facettes étant inclinées par rapport à ladite face principale, forment au moins des parties des limites latérales opposées de ladite rainure.

2. Composant selon la revendication 1, dans lequel les bornes opposées de la couche active sont en contact respectivement avec lesdites limites latérales opposées de la rainure.

3. Composant selon la revendication 1 ou 2, dans lequel la rainure a une section transversale en forme de V.

4. Composant selon la revendication 1 ou 2, dans lequel ladite rainure (13) est limitée par deux parties limites latérales opposées qui s'étendent depuis ladite face principale, dans ledit corps, pratiquement perpendiculairement à cette face principale, une partie limite inférieure s'étendant pratiquement parallèlement à ladite face principale et deux parties limites inclinées qui sont formées respectivement par lesdites facettes (111)B et relient respectivement lesdites parties limites latérales opposées aux bords opposés de ladite partie limite inférieure.

5. Composant selon la revendication 3 ou 4, dans lequel la largeur maximale de la rainure est 4 μm.

6. Composant selon l'une quelconque des revendications précédentes, dans lequel ledit corps de matière semi-conductrice consiste en un substrat (11) de InP de type avec une couche (12) de InP de type p

**0 061 938**

formée sur lui et dans lequel la rainure (13) s'étend en profondeur à travers la couche de InP de type p dans ledit substrat.

# Fig. 1

## Fig. 2

## Fig. 3

# Fig. 4

# Fig. 5

# Fig. 6

# Fig. 7

## *Fig. 8*

TOTAL LENGTH OF UNCOVERED
PORTION OF CLAD GUIDE LAYER
IN THE GROOVE

$\ell_1 + \ell_2 \ (\mu m)$

## Fig. 9

Fig. 10 A

Fig. 10 B